# EUROPÄISCHE PATENTSCHRIFT

(11) **EP 1 543 568 B1**
(45) Veröffentlichungstag und Bekanntmachung des Hinweises auf die Patenterteilung: **22.08.2007**
(21) Anmeldenummer: 03769225.8
(22) Anmeldetag: 29.09.2003
(51) Int. Cl.: H01L 41/107

(54) **PIEZOELEKTRISCHER TRANSFORMATOR MIT CU-INNENELEKTRODEN**
PIEZOELECTRIC TRANSFORMER PROVIDED WITH INTERNAL COPPER ELECTRODES
TRANSFORMATEUR PIEZOELECTRIQUE A ELECTRODES INTERNES EN CUIVRE

(30) Priorität: 27.09.2002 DE 10245130
(43) Veröffentlichungstag der Anmeldung: 22.06.2005
(73) Patentinhaber: EPCOS AG, 81669 München (DE)
(72) Erfinder: GLAZOUNOV, Alexandre, A-8530 Deutschlandsberg (AT)
(74) Vertreter: Epping - Hermann - Fischer
(86) Internationale Anmeldenummer: PCT/DE2003/003239
(87) Internationale Veröffentlichungsnummer: WO 2004/032255

(56) Entgegenhaltungen:
- EP-A- 0 395 018
- WO-A-02/053514
- DE-A- 10 062 672
- US-A- 4 353 958
- PATENT ABSTRACTS OF JAPAN Bd. 1999, Nr. 13, 30. November 1999 (1999-11-30) -& JP 11 228223 A (TOTO LTD), 24. August 1999 (1999-08-24)

## Beschreibung

Die vorliegende Erfindung betrifft einen mehrschichtigen piezoelektrischen Transformator, enthaltend einen Bleizirkonat-Titanat, Pb(ZrₓTi₁₋ₓ)O₃ oder PZT, Keramikkörper und innenliegende Kupferelektroden, und ferner ein Verfahren zur Herstellung eines solchen Transformators.

Piezoelektrische Transformatoren wurden im Jahr 1954 von Rosen et al. erfunden (US-Patent 2,830,274). Ihre prinzipielle Arbeitsweise besteht darin, zuerst ein elektrisches Eingangssignal in mechanische Schwingungen des Transformatorkörpers umzuwandeln und anschließend die Energie der mechanischen Schwingungen in ein elektrisches Ausgangssignal zurückzuwandeln. Die zweifache Energieumwandlung passiert mittels des piezoelektrischen Effekts. Die Wirkung des Transformators, d.h. der Spannungsanstieg wird erreicht durch Benutzung von Eigenschaften des Keramikmaterials, wie des mechanische Qualitätsfaktors Qₘ, der elektromechanische Koppelkoeffizienten kᵢⱼ, und einer Struktur des Transformators wie des Elektrodenabstands in seinem primären und sekundären Teil.

Aus der Druckschrifts JP 11228223 A ist eine Keramikzusammensetzung für piezoelektrische Transformatoren bekannt. Aus der Druckschrift EP 0 395 018 ist ein piezoelektrisches Bauelement und ein Herstellverfahren bekannt.

Seitdem wurde eine große Anzahl von technischen Veröffentlichungen publiziert und in der ganzen Welt wurde eine hohe Anzahl von Patenten erteilt, welche folgende Ziele verfolgten: (i) neue Entwürfe von piezoelektrischen Transformatoren, (ii) neue piezoelektrische Materialien für die Anwendung in Transformatoren, und (iii) elektronische Schaltkreise, welche piezoelektrische Transformatoren enthalten. Insbesondere wurden mehrschichtige piezoelektrische Transformatoren entwickelt, bestehend aus piezoelektrischen Keramiken, welche mit innenliegenden Metallelektroden gemeinsam gesintert sind. Der Vorteil des Vielschichtentwurfs ist die Möglichkeit, das Spannungsanstiegsverhältnis durch Einstellung des Abstands zwischen den Innenelektroden in dem primären oder sekundären Teil anzuheben. Somit kann bei einem vorgegebenen Spannungsanstiegsverhältnis die Größe des Transformators durch Nutzung der Vielschichtstruktur reduziert werden.

Dieses starke Interesse an piezoelektrischen Transformatoren kann erklärt werden durch den Glauben, daß diese Komponenten elektromagnetische Transformatoren in vielen Anwendungen ersetzen können, zuerst dort, wo eine vergleichsweise geringe Leistung unter 20 W und eine geringe Größe des Transformators erforderlich ist. Solche Anwendungen umfassen (i) Hintergrundbeleuchtungsinverter für Flüssigkristallanzeigen in Laptops und kürzlich in "Hand-held-Organizers", Video- und Fotokameras, (ii) Vorschaltgeräte für fluoreszierende Lampen und (iii) Wechselstrom-Gleichstrom-Wandler für Mobiltelefone, Laptops und andere wiederaufladbare handgehaltene Geräte.

Es werden die folgenden Vorteile von piezoelektrischen Transformatoren gegenüber elektromagnetischen genannt:
(i) hohe Leistungsdichte des piezoelektrischen Materials, welches den Aufbau eines kompakten Transformators mit kleineren Dimensionen ermöglicht, insbesondere einer kleineren Dikke als die der elektromagnetischen Transformatoren;
(ii) geringer Energieverlust und daher eine höhere Effizienz des Transformators. Anders als die elektromagnetischen Transformatoren enthalten die piezoelektrischen Transformatoren keine Verdrahtung im primären und sekundären Teil und sind daher frei von verdrahtungsbedingten Verlusten, wie Verluste durch Induktionsströme und den Skineffekt in Metallen;
(iii) höhere Zuverlässigkeit, welche zusammenhängt mit dem reduzierten Risiko eines Kurzschlusses zwischen dem primären und dem sekundären Teil aufgrund des Nichtvorhandenseins von Verdrahtungen;
(iv) piezoelektrische Transformatoren erzeugen kein elektromagnetisches Rauschen und stören daher keine angrenzenden Schaltungen, die empfindlich gegenüber magnetischen Feldern sein können.

Trotz der oben genannten technischen Vorteile von piezoelektrischen Transformatoren haben die elektromagnetischen Transformatoren einen bezeichnenden Vorteil: niedrige Herstellungskosten aufgrund der Produktion großer Stückzahlen über lange Zeiten, welche merklich geringer sind als die Herstellungskosten von mehrschichtigen piezoelektrischen Transformatoren. Die vergleichsweise hohen Herstellungskosten der piezoelektrischen Transformatoren werden zu einem größeren Teil bestimmt durch die Kosten für teure Metallelektroden, welche typischerweise aus Platin oder aus einer Silber/Palladium-Legierung gefertigt sind. Solche teuren Metalle werden benötigt für die Gemeinsamsinterung mit PZT-Keramiken bei hohen Temperaturen zwischen 1100 und 1200° C, welche erforderlich sind, um dichte PZT-Keramiken mit guten Eigenschaften, wie hohe piezoelektrische Koppelkoeffizienten herzustellen.

Um die Gemeinsamsinterung keramischer Materialien mit Elektroden aus billigen Metallen, wie Silber oder Kupfer zu ermöglichen, muß die Sintertemperatur der Keramiken unter den Schmelzpunkt des Metalls, welcher für Kupfer 1085° C und für Silber 962° C beträgt, gesenkt werden. Zusätzlich dazu, falls Kupferelektroden verwendet werden, muß das Sintern in einer Inertatmosphäre stattfinden, um die Oxidation von Kupfer zu vermeiden. Gemeinsamsinterung von Keramiken mit Silberelektroden kann in oxidierender Atmosphäre (Luft) stattfinden.

Zur Zeit kann auf die folgenden vier Veröffentlichungen Bezug genommen werden, welche die Gemeinsamsinterung piezoelektrischer Keramiken mit Kupfer oder Silber behandeln.

Es gibt zwei Veröffentlichungen, welche die Methode der Sinterung von piezoelektrischen Keramiken bei 900° beschreiben, insbesondere die Methode der Herstellung eines mehrschichtigen piezoelektrischen Transformators mit innenliegenden Silberelektroden. In dem US-Patent 5,792,379 wird eine Sinterung bei 900° C erreicht durch Mischen einer PZT-Keramik mit einer speziell präparierten Glasfritte, die aus einer Kombination von B₂O₃, Bi₂O₃, Cu und gleichartiger anderer Metalloxide, wie ZnO, BaO, etc. zusammengesetzt ist.

In der anderen Patentanmeldung WO 200121548 wird Sinterung bei 900° C erreicht durch Mischung von PZT-Keramiken mit einer Kombination von Bi₂O₃ und CdO, welche eine geringe Schmelztemperatur aufweist und daher die Verdichtung der PZT-Keramik unterstützt. Es wurde beansprucht, daß der Vorteil der Verwendung von Bi₂O₃ und CdO anstelle von Glasfritte wäre, daß sowohl Bi als auch Cd in das Kristallgitter von PZT eingebaut werden können und daher keine unerwünschten sekundären Phasen bilden sollten, welche für die Eigenschaften der Keramik nachteilig sein können. In beiden Arbeiten wird eine dichte Keramik durch Sinterung bei 900° C erreicht.

Jedoch hatten die in den beiden Patenten beschriebenen Keramiken schlechte Eigenschaften, insbesondere vergleichsweise niedrige Werte der elektromechanischen Koppelkoeffizienten kp = 0,45 - 0,47, mechanische Qualitätsfaktoren Qₘ = 500 - 650 und dielektrische Konstanten ε₃₃ = 400 - 550. Die niedrigen Werte dieser Materialparameter können schlechte Charakteristiken der Transformatoren zur Folge haben, wie ein niedriges Spannungsanstiegsverhältnis, niedrige Leistung und niedrige Effizienz. Solche schlechten Eigenschaften der Keramiken können die Folge von Sinterung von Keramiken bei niedrigen Temperaturen von 900° C sein. Besonders bei niedrigen Temperaturen könnte das Kornwachstum eingeschränkt sein und niedrige Diffusionsraten könnten keine homogene Verteilung von Zirkon und Titan im Kristallgitter von PZT bereitstellen.

Angesichts dessen mag Gemeinsamsinterung mit Kupferelektroden als eine bessere technologische Möglichkeit für die Herstellung von mehrschichtigen piezoelektrischen Transformatoren mit hoher Leistung erscheinen, da höhere Sintertemperaturen von 1000° C anstelle von 900° C zu PZT-Keramiken mit besseren Eigenschaften führen sollten.

Es kann Bezug genommen werden auf zwei Patentanmeldungen, welche die Gemeinsamsinterung von mehrschichtigen piezoelektrischen Keramikbauteilen mit inneren Kupferelektroden beschreiben. Eine dieser, DE 19946834-A1 beschreibt einen mehrschichtigen piezoelektrischen Aktor mit innenliegenden Kupferelektroden und ein Verfahren zur Herstellung desselben. Es ist beschrieben, daß es möglich ist, mehrschichtigen piezoelektrische Aktoren mit innenliegenden Kupferelektroden herzustellen, jedoch werden keine spezifischen Details angegeben, wie das zu erreichen sei.

Eine andere Patentanmeldung, DE 10062672-A1 beschreibt mehrschichtige piezoelektrische Komponenten mit innenliegenden Kupferelektroden und das Verfahren zur Herstellung derselben. Zuerst beschreibt diese Anmeldung detailliert das Verfahren der Gemeinsamsinterung von piezoelektrischen Keramiken mit innenliegenden Kupferelektroden, welches Komponenten von hoher Dichte und hoher Leistung ergibt. Als zweites betrifft die Veröffentlichung mehrschichtige piezoelektrische Komponenten im allgemeinen, welche auch Vielschichttransformatoren umfassen können. Das Verfahren zur Herstellung solcher Komponenten ist für mehrschichtige piezoelektrische Aktoren beschrieben.

Der Hauptunterschied zwischen piezoelektrischen Aktoren und piezoelektrischen Transformatoren ist der, daß die erstgenannten, insbesondere die Aktoren, die in DE 10062672-A1 beschrieben sind, aus einer sogenannten "soft"-piezoelektrischen Keramik gefertigt sind. "soft"-piezoelektrische Keramiken werden erhalten durch Dotierung einer Grundzusammensetzung Pb(ZrₓTi₁₋ₓ)O₃ mit wenigen Mol-% von Donatorzusätzen, welche hochvalente Kationen sind wie Nd³⁺ als Ersatz für Pb²⁺ wie in der Patentanmeldung DE 10062672-A1 beschrieben. "Soft"-piezoelektrische Keramik unterscheidet sich durch hohe Werte des piezoelektrischen Ladungskoeffizienten dᵢⱼ und der dielektrischen Konstante εᵢᵢ, jedoch gleichzeitig durch hohe dielektrische und mechanische Verluste, welche durch tan δ und den reziproken mechanischen Qualitätsfaktor 1/Qₘ repräsentiert werden. Hohe mechanische Verluste implizieren niedrige mechanische Qualitätsfaktoren Qₘ. Insbesondere hat eine PZT-Keramik, welche mit Nd dotiert ist, ein tan δ > 2 % und ein Qₘ = 50 - 70. Solche Werte sind für die Anwendung in piezoelektrischen Transformatoren ungeeignet, weil solche Transformatoren eine niedrige Effizienz aufweisen werden.

Piezoelektrische Transformatoren werden üblicherweise hergestellt durch Verwendung von "hard"-piezoelektrischen Keramiken. "Hard"-Keramik wird erhalten durch Dotieren der Grundzusammensetzung Pb(ZrₓTi₁₋ₓ)O₃ mit wenigen Mol-% eines Akzeptorzusatzes, welcher ein niedervalentes Kation ist, so wie Mn²⁺, Fe²⁺, Ni²⁺, Zn²⁺, Mg²⁺, Li¹⁺ {als Ersatz für Zr⁴⁺ oder Ti⁴⁺} oder Ag¹⁺ (als Ersatz für Pb²⁺). "Hard"-PZT-Keramiken sind charakterisiert durch niedrige mechanische (Qₘ = 1000 - 2000) und dielektrische (tan δ = 0,3 - 0,4 %) Verluste.

Bis jetzt wurden alle bekannten Zusammensetzungen von "hard"-piezoelektrischen Keramiken entwickelt für Keramiken, die in oxidierender Atmosphäre (Luft) gesintert werden. Bis jetzt wurde nicht untersucht, wie die Eigenschaften von "Hard"-PZT-Keramiken, welche mit solchen Zusätzen dotiert sind, während des Sinterns in Inertatmosphäre geändert werden. Die Patentanmeldung DE 10062672-A1 lehrt lediglich die Herstellung von "soft"-piezoelektrischen Keramiken. Es ist möglich, daß Gemeinsamsinterung in einer Inertatmosphäre nachteilig für die piezoelektrischen Eigenschaften von "Hard"-PZT-Keramiken ist, was möglicherweise die Keramiken ungeeignet für Anwendungen in piezoelektrischen Transformatoren macht.

Die vorliegende Erfindung beschreibt mehrschichtige piezoelektrische Transformatoren, welche hergestellt werden durch Gemeinsamsinterung von "hard"-piezoelektrischen Keramiken mit innenliegenden Kupferelektroden. Die Verwendung von Kupferelektroden muß die Herstellungskosten des Transformators wesentlich reduzieren, was sie auf dem Markt konkurrenzfähiger machen sollte. Dies sollte als hauptsächliche Verbesserung betrachtet werden verglichen mit Vielschichttransformatoren, welche mit Silber/Palladium oder innenliegenden Platinelektroden gemeinsam gesintert werden.

Die vorliegende Erfindung weist einen Vorteil gegenüber einer Technologie, wo mehrschichtige piezoelektrische Transformatoren mit innenliegenden Silberelektroden hergestellt werden, darin auf, daß höhere Temperaturen für die Gemeinsamsinterung, nämlich 1000° C gegenüber 900° C in Keramiken mit verbesserten Eigenschaften resultieren. Dies liegt daran, daß höhere Temperaturen das Kornwachstum und eine homogenere Verteilung von Zirkon und Titan im Kristallgitter von PZT fördern.

Verglichen mit der existierenden Technologie von mehrschichtigen piezoelektrischen Transformatoren besteht die Erfindung darin, daß Kupferelektroden mit "hard"-piezoelektrischen Keramiken gemeinsam gesintert werden.

Die Herstellungsmethode ausgehend vom Pulver bis zur Gemeinsamsinterung der Keramiken mit Kupferelektroden wurde von der Patentanmeldung von EPCOS, DE 10062672-A1 übernommen. Verglichen mit dieser Arbeit weist die vorliegende Erfindung die Neuheit auf, daß sie "hard"-piezoelektrische Keramiken anstelle der dort beschriebenen "Soft"-Keramiken verwendet.

Mehrschichtige piezoelektrische Transformatoren mit innenliegenden Kupferelektroden wurden erfolgreich hergestellt. Die Transformatoren weisen verschiedene Entwürfe auf, die unterschiedliche Formgebungen und unterschiedliche Elektrodenformen enthalten. Bis jetzt wurden nur Transformatoren eines einzigen Entwurfs charakterisiert. Die Charakteristiken des Transformators stimmen mit den Anforderungen von Anwendungen in Wechselstrom-Gleichstrom-Wandler überein, für welche dieser Transformator entworfen wurde.

Die Keramikzusammensetzung hat die allgemeine Formel Pb(ZrₓTi₁₋ₓ)O₃ +y Pb(Mn_{1/3}Nb_{2/3})O₃. Diese Zusammensetzung ist im Stand der Technik bekannt und hat Eigenschaften, die für die Anwendung in piezoelektrischen Transformatoren geeignet sind. Der Entwurf für den Transformator, eingeschlossen die Formgebung der Elektroden, kann so wie sie für die Anwendung des Kunden gebraucht wird gewählt werden, für den der Transformator hergestellt wurde. Der Verfahrensablauf, eingeschlossen die Entfernung eines anorganischen Binders und die Einstellung der Inertatmosphäre während des Sinterns ist beschrieben in der Patentanmeldung DE 10062672-A1.

Die Erfindung gemäß Anspruch 1 nutzt den Schritt des Sinterns einer "Hard"-PZT-Keramik in der Inertatmosphäre bei 1000° C, welcher zu einer Dichte der Keramik führt, welcher größer ist als die von Keramiken mit derselben chemischen Zusammensetzung, jedoch gesintert bei 1000° C in einer oxidierenden Atmosphäre, beispielsweise Luft. Die Möglichkeit, "Hard"-PZT-Keramik mit hoher Dichte durch Sintern in der Inertatmosphäre zu erhalten, vereinfacht den Herstellungsprozeß des Transformators, da keine Zusätze wie im Stand der Technik beschrieben benötigt werden. Diese Zusätze wurden entwickelt, um die Sintertemperatur der Keramik in der oxidierenden Atmosphäre, beispielsweise Luft zu reduzieren.

Das Sintern in der Inertatmosphäre verbessert die Eigenschaften der "hard"-piezoelektrischen Keramik, die von entscheidender Bedeutung für die Anwendung in piezoelektrischen Transformatoren sind. Insbesondere werden die dielektrischen Verluste vermindert und der elektromechanische Koppelkoeffizient wird verglichen mit Keramiken mit derselben chemischen Zusammensetzung, welche bei 1000° C in oxidierender Atmosphäre (Luft) gesintert wurden, erhöht.

## Patentansprüche

1. Verfahren zur Herstellung eines Transformators, wobei Kupferelektroden gemeinsam mit keramischen Grünfolien bei einer Temperatur von 1000° C in Inertatmosphäre gesintert werden und wobei die keramischen Grünfolien eine Zusammensetzung der allgemeinen Formel Pb(ZrₓTi₁₋ₓ)O₃ haben,
wobei aus der Zusammensetzung durch Dotieren mit wenigen Mol-% eines niedervalenten Kations als Ersatz nur für Zr⁴⁺ oder Ti⁴⁺ eine harte piezoelektrische Keramik gebildet ist.

2. Verfahren nach Anspruch 1,
wobei die Keramik bei einer Temperatur unterhalb dem Schmelzpunkt von Kupfer gesintert wird.

## Claims

1. Method for producing a transformer, wherein copper electrodes are sintered jointly with ceramic green sheets at a temperature of 1000°C in an inert atmosphere, and wherein the ceramic green sheets have a composition of the general formula Pb(ZrₓTi₁₋ₓ)O₃, wherein a hard piezoelectric ceramic is formed from the composition by doping with a few mol% of a low-valency cation as replacement only for Zr⁴⁺ or Ti⁴⁺.

2. Method according to Claim 1, wherein the ceramic is sintered at a temperature below the melting point of copper.

## Revendications

1. Procédé de fabrication d'un transformateur en frittant des électrodes en cuivre conjointement à des feuilles crues en céramique dans une atmosphère inerte à une température de 1 000°C et les feuilles crues en céramique ayant une composition de formule générale Pb(ZrₓTi₁₋ₓ)O₃, en formant à partir de la composition par dopage par peu de pourcents en mole d'un cation de petite valence en remplacement seulement de Zr⁴⁺ ou Ti⁴⁺, une céramique piézoélectrique dure.

2. Procédé suivant la revendication 1,
dans lequel on fritte la céramique à une température inférieure au point de fusion du cuivre.
